# EUROPÄISCHE PATENTANMELDUNG

(11) **EP 4 271 152 A1**
(43) Veröffentlichungstag der Anmeldung: **01.11.2023**
(21) Anmeldenummer: 22170266.5
(22) Anmeldetag: 27.04.2022
(51) Int. Cl.: H05K 7/14

(54) **ELEKTRONISCHE BAUGRUPPE MIT ZUMINDEST EINER LEITERPLATTE UND EXTERNEN ELEKTRONISCHEN BAUTEILEN SOWIE WECHSELRICHTER MIT EINER SOLCHEN ELEKTRONISCHEN BAUGRUPPE**

(71) Anmelder: FRONIUS INTERNATIONAL GmbH, 4643 Pettenbach (AT)
(72) Erfinder: GROTTENTHALER, Patrick, 4643 Pettenbach (AT); SCHNETZER, Alexander, 4643 Pettenbach (AT); EDLINGER, Harald, 4643 Pettenbach (AT); WIESINGER, Manfred, 4643 Pettenbach (AT)
(74) Vertreter: SONN Patentanwälte OG

(57) **Zusammenfassung**

Die Erfindung betrifft eine elektronische Baugruppe (1) mit zumindest einer Leiterplatte (2) und externen elektronischen Bauteilen (3) mit elektrischen Anschlüssen (4), wobei die Leiterplatte (2) Kontakte (5) zur Verbindung mit den Anschlüssen (4) der externen elektronischen Bauteile (3) aufweist, und die zumindest eine Leiterplatte (2) und die externen Bauteile (3) an einem Gehäuseteil (6) befestigbar sind, sowie einen Wechselrichter mit einem Leistungsteil. Erfindungsgemäß ist ein am Gehäuseteil (6) verschiebbar gelagerter Träger (7) vorgesehen, wobei der Träger (7) Halterungen (8) zur Aufnahme von Kontaktelementen (9) zur Verbindung mit den Anschlüssen (4) der externen elektronischen Bauteile (3) und zur Verbindung mit den Kontakten (5) auf der Leiterplatte (2) aufweist.

## Beschreibung

Die Erfindung betrifft eine elektronische Baugruppe mit zumindest einer Leiterplatte und externen elektronischen Bauteilen mit elektrischen Anschlüssen, wobei die Leiterplatte Kontakte zur Verbindung mit den Anschlüssen der externen elektronischen Bauteile aufweist, und die zumindest eine Leiterplatte und die externen Bauteile an einem Gehäuseteil befestigbar sind.

Weiters betrifft die Erfindung einen Wechselrichter, insbesondere Photovoltaik-Wechselrichter, mit einem Leistungsteil.

Die Erfindung bezieht sich grundsätzlich auf allgemeine elektronische Baugruppen, welche zumindest eine Leiterplatte und auch externe elektronische Bauteile aufweisen, welche mit der Leiterplatte entsprechend verbunden werden. Die Leiterplatte und die externen Bauteile sind üblicherweise in einem Gehäuse angeordnet bzw. an einem Gehäuseteil befestigt. Bei den externen elektronischen Bauteilen handelt es sich meist um Bauteile höherer Leistung und größeren Volumens, weshalb sie nicht direkt an der Leiterplatte befestigt oder angelötet sind. So werden beispielsweise größere Drosseln oder größere Kondensatoren, welche mehr Verlustwärme erzeugen, häufig bewusst abseits der Leiterplatte, beispielsweise in oder an einem eigenen Kühlkörper platziert. Die elektrische Verbindung zwischen dem externen elektronischen Bauteil und entsprechenden Kontakten auf der Leiterplatte erfolgt üblicherweise über Kabel, an deren Enden Schraubkontakte angeordnet sind, welche mit den Kontakten auf der Leiterplatte verschraubt werden.

Beispielsweise handelt es sich bei der elektronischen Baugruppe um einen Wechselrichter oder einen Teil des Wechselrichters, beispielsweise dem Leistungsteil. Bei derartigen Wechselrichtern, insbesondere Photovoltaik-Wechselrichtern, werden einzelne Baugruppen, wie zum Beispiel der AC-seitige Leistungsteil oder der DC-seitige Leistungsteil mit entsprechenden externen elektronischen Bauteilen, wie zum Beispiel Drosseln, in geeigneter Weise in einem Gehäuse angeordnet. Zu Wartungszwecken ist es von Vorteil, einen möglichst raschen und einfachen Tausch der elektronischen Baugruppen zu ermöglichen.

Eine Kontaktierung externer Drosseln mit der Leiterplatte über Schraubverbindungen ist entsprechend aufwändig. Dementsprechend zeit- und kostenintensiv ist eine generelle Wartung oder ein Tausch von Komponenten des Wechselrichters, beispielsweise eine Reparatur der Leiterplatte des Leistungsteils. Erschwert wird das noch dadurch, dass häufig Bauelemente, insbesondere Halbleiterbauteile, welche direkt an der Leiterplatte angelötet sind, zur Kühlung mit entsprechenden Kühlkörpern verbunden werden. Oft ist zwischen den Halbleiterbauteilen und den Kühlkörpern noch eine Wärmeleitpaste für eine bessere Wärmeleitung angeordnet, wodurch sich eine Demontage der Leiterplatte noch aufwändiger gestaltet.

Darüber hinaus kann es beim Verschrauben der Kontakte von externen Bauteilen mit der Leiterplatte zu einem Verkanten der Schrauben kommen, wodurch ein Lösen der Schraubverbindung nur mehr mit großem Aufwand möglich ist.

Teilweise bieten Steckverbindungen zwischen den Leiterplatten und externen elektronischen Bauteilen hier Vorteile. Allerdings kann es aufgrund von Toleranzen und von Verschiebungen der externen elektronischen Bauteilen gegenüber der Leiterplatte wieder zu Problemen beim Herstellen der Verbindung zwischen der Leiterplatte und den Kontakten der externen elektronischen Bauteilen kommen.

Beispielsweise beschreibt die DE 10 2008 004 882 A1 eine Steckverbindung, bei der die Positionierung der Steckverbindung zur Leiterplatte und somit die elektrische Verbindung zwischen dem Kontaktstift und einem entsprechenden Gegenstück auf der Leiterplatte unterstützt wird.

Die Aufgabe der vorliegenden Erfindung besteht in der Schaffung einer elektronischen Baugruppe und einem Wechselrichter der oben genannten Art, welche einen raschen und einfachen Tausch einzelner Komponenten unterstützen. Nachteile des Standes der Technik sollen vermieden oder zumindest reduziert werden.

Gelöst wird die erfindungsgemäße Aufgabe durch eine oben genannte elektronische Baugruppe, bei der ein am Gehäuseteil verschiebbar gelagerter Träger vorgesehen ist, wobei der Träger Halterungen zur Aufnahme von Kontaktelementen zur Verbindung mit den Anschlüssen der externen elektronischen Bauteilen und zur Verbindung mit den Kontakten auf der Leiterplatte aufweist. Kern der Erfindung stellt also der verschiebbar gelagerte Träger mit Halterungen zur Aufnahme von Kontaktelementen dar. Die am Träger angeordneten Kontaktelemente sind einerseits mit den Anschlüssen der externen elektronischen Bauteilen verbunden, was durch entsprechende Kabel- und Lötverbindungen aber auch Schraubverbindungen geschehen kann. Andererseits stellen die am Träger angeordneten Kontaktelemente die Verbindung mit entsprechenden Kontakten auf der Leiterplatte her. Durch die verschiebbare Lagerung des Trägers können Toleranzen leichter ausgeglichen und die Verbindung der Kontaktelemente mit der Leiterplatte erleichtert werden. Auch wird durch die verschiebbare Lagerung des Trägers im verbundenen Zustand mit der Leiterplatte ein Lösen allfälliger Bauteile von Kühlkörpern erleichtert. Durch entsprechende Gestaltung des Trägers und der Kontaktelemente zur Verbindung mit den Anschlüssen der externen elektronischen Bauteilen und zur Verbindung mit den Kontakten auf der Leiterplatte kann ein Tausch einzelner Komponenten der elektronischen Baugruppe, wie zum Beispiel der Leiterplatte oder externer elektronischer Bauteile, erleichtert und eine rasche Reparatur oder ein rascher Tausch der Komponenten unterstützt. Der herstellungstechnische Mehraufwand durch die Konstruktion des verschiebbar am Gehäuseteil gelagerten Trägers ist sehr gering.

Vorzugsweise ist der Träger in einer Richtung verschiebbar gelagert. Eine Verschiebbarkeit in einer Richtung reicht meist zum Ausgleich von Toleranzen in Bezug auf den Gehäuseteil und die zu verbindende Leiterplatte aus und ist leicht herzustellen.

Beispielsweise kann die verschiebbare Lagerung des Trägers in einer Richtung gegenüber dem Gehäuseteil, mit dem der Träger verbunden wird, sehr einfach dadurch realisiert werden, dass der Träger zumindest ein Langloch zur Aufnahme eines Befestigungselements, insbesondere einer Befestigungsschraube, aufweist, welches Befestigungselement mit dem Gehäuseteil verbindbar ist. Die Verschiebbarkeit in einer Richtung kann durch ein solches Langloch und eine geeignete Führung oder zwei oder mehr Langlöcher mit gleicher Orientierung der Längsachsen der Langlöcher realisiert werden.

Wenn in zumindest einem Langloch eine Rastnase oder dgl. angeordnet ist, kann eine bestimmte Vorzugsposition für das Befestigungselement festgelegt werden. Diese Vorzugsposition kann durch Überwindung des Hindernisses der Rastnase oder dgl. überwunden und verlassen werden, sollte dies bei Toleranzen der Leiterplatte oder des Gehäuseteils gegenüber dem Träger erforderlich sein.

Der Träger ist bevorzugt aus Kunststoff, beispielsweise aus Polyamid, gebildet. Dadurch ist eine besonders einfache und kostengünstige Herstellung möglich und es können die in den Halterungen angeordneten Kontaktelemente voneinander elektrisch isoliert werden. Beispielsweise können die Träger samt den Halterungen und den Langlöchern oder dgl. für die Aufnahme der Befestigungselemente zur Befestigung am Gehäuseteil durch Spritzgießverfahren sehr einfach und kostengünstig produziert werden.

Wenn der Träger als Gitter ausgebildet ist, kann das Gewicht und des Trägers weitgehend reduziert werden und der Zugang zu Komponenten, wie zum Beispiel zu den unter dem Träger angeordneten externen elektronischen Bauteilen erleichtert werden.

Gemäß einem weiteren Merkmal der Erfindung ist am Träger zumindest ein Zentrierstift angeordnet, welcher in eine entsprechende Zentrieröffnung an der Leiterplatte anordenbar ist. Durch solche Zentrierstifte kann die richtige Positionierung der Leiterplatte in Bezug auf die am Träger angeordneten Kontaktelemente unterstützt werden. Ein solcher Zentrierstift am Träger kann insbesondere beim Herstellen des Trägers aus einem Kunststoff im Spritzgießverfahren sehr einfach realisiert werden. Das entsprechende Gegenstück an der Leiterplatte in Form einer Zentrieröffnung, allenfalls eine konische Bohrung, ist ebenfalls sehr einfach und kostengünstig herstellbar.

Vorzugsweise ist das Kontaktelement durch einen Stecker gebildet, welcher mit einer komplementär gestalteten Buchse an der Leiterplatte verbindbar ist. Durch eine solche Konstruktion kann die Verbindung zwischen den Kontaktelementen am Träger und der Leiterplatte besonders rasch und einfach und werkzeuglos hergestellt und wieder gelöst werden. Je nach Stärke des Stromes, der über den jeweiligen Kontakt fließen wird, müssen die Kontakte und Buchsen mit entsprechendem Querschnitt gewählt werden, um lokale Überhitzungen und Probleme oder sogar die Zerstörung der Kontaktelemente zu vermeiden.

Alternativ zur oben genannten Steckverbindung kann das Kontaktelement auch als Schraubverbindung ausgebildet sein, indem das Kontaktelement beispielsweise ein Innengewinde zur Aufnahme einer Schraube mit einem entsprechenden Außengewinde aufweist. Dadurch wird der Montage- und Demontageaufwand zwar etwas vergrößert, da die Schraubverbindung manuell oder automatisiert geschlossen oder gelöst werden muss. Allerdings kann es bei höheren übertragenen Strömen und höheren Leistungsklassen erforderlich oder sogar vorgeschrieben sein, anstelle von Steckkontakten Schraubkontakte zu verwenden.

Vorzugsweise ist am Gehäuseteil der elektronischen Baugruppe ein Kühlkörper angeordnet, welcher Kühlkörper mit an der Unterseite der Leiterplatte angeordneten Bauteilen kontaktierbar ist. Auf diese Weise können Bauteile mit höherer Verlustwärme durch entsprechende Gestaltung der Leiterplatte vornehmlich an deren Unterseite angeordnet werden und dort bei der Montage automatisch mit einem geeigneten Kühlkörper kontaktiert werden. Die Größe und das Material des Kühlkörpers wird an die abzuführende Wärmemenge entsprechend angepasst.

Zwischen den Bauteilen und dem Kühlkörper ist eine Wärmeleitpaste anordenbar, welche die Wärmeleitung von den an der Unterseite der Leiterplatte angeordneten Bauteilen zum Kühlkörper entsprechend verbessert. Als Wärmeleitpaste kann beispielsweise auch ein sogenanntes Phase Change Material zur Anwendung kommen, eine geeignete Substanz, welche Wärmeenergie absorbieren kann.

Wenn die Leiterplatte zumindest eine Öffnung aufweist, kann der Zugang unter die Leiterplatte an entsprechenden Stellen ermöglicht werden, um beispielsweise Befestigungselemente zu lösen oder zu anderen Komponenten der elektronischen Baugruppe zu gelangen. Auch kann über eine derartige Öffnung ein Werkzeug angeordnet werden, um die Leiterplatte durch seitliche Verschiebung von Kühlkörpern zu lösen, indem eine Verbindung zwischen Bauteilen und einem Kühlkörper in Form einer gehärteten Wärmeleitpaste oder dgl. aufzubrechen. Auch das erleichtert eine Demontage der Leiterplatte und beschleunigt somit deren Tausch oder Reparatur.

Die externen elektronischen Bauteile können beispielsweise durch Drosseln gebildet sein, welche aufgrund der höheren Leistungsklasse abseits von der Leiterplatte angeordnet und mit entsprechenden Kabelverbindungen mit Kontakten auf der Leiterplatte elektrisch verbunden werden. Auch größere Kondensatoren, Transformatoren oder Leistungshalbleiter sind als externe elektronische Bauteile vorstellbar.

Zur Kühlung können die Drosseln in sogenannten Drosselschalen angeordnet sein, entsprechend gestalteten und angepassten Kühlkörpern vorzugsweise aus Aluminium oder Aluminiumlegierungen. Neben der Kühlung der Drosseln stellen die Drosselschalen auch eine entsprechende mechanische Aufnahme für die Drosseln. Gegebenenfalls können die Drosseln in den Drosselschalen über Wärmeleitpasten platziert und gegebenenfalls mit Befestigungselementen zusätzlich gesichert werden.

Gelöst wird die erfindungsgemäße Aufgabe auch durch einen oben genannten Wechselrichter, insbesondere Photovoltaik-Wechselrichter, mit einem Leistungsteil, welcher Leistungsteil als elektronische Baugruppe mit den oben erwähnten Merkmalen ausgebildet ist. Dadurch kann ein Wechselrichter realisiert werden, dessen Komponenten, insbesondere der Leistungsteil besonders rasch und einfach ausgetauscht werden kann. Dadurch können die Wechselrichter im Falle eines Defekts kostengünstiger repariert werden. Zu den übrigen Vorteilen wird auf die obige Beschreibung der elektronischen Baugruppe verwiesen.

Die vorliegende Erfindung wird anhand der beigefügten Zeichnungen näher erläutert. Darin zeigen
- Fig. 1: schematisch eine elektronische Baugruppe mit einer Leiterplatte und einem externen elektronischen Bauteil nach dem Stand der Technik;
- Fig. 2: schematisch eine elektronische Baugruppe mit einer Leiterplatte und einem externen elektronischen Bauteil nach der vorliegenden Erfindung;
- Fig. 3: eine perspektivische Ansicht auf einen speziell gestalteten Gehäuseteil mit darin angeordneten externen elektronischen Bauteilen und einem erfindungsgemäßen Träger zur Unterstützung der Verbindung der externen elektronischen Bauteilen mit einer Leiterplatte;
- Fig. 4: eine Detailansicht auf den Träger aus Fig. 3 von oben;
- Fig. 5: eine Draufsicht auf eine elektronische Baugruppe mit Gehäuseteilen mit externen elektronischen Bauteilen, entsprechenden Trägern und einem Kühlkörper zur Kühlung von Bauteilen, welche an der Unterseite einer darüber anordenbaren Leiterplatte platziert sind; und
- Fig. 6: einen Teil der elektronischen Baugruppe gemäß Fig. 5 mit darüber angeordneter Leiterplatte.

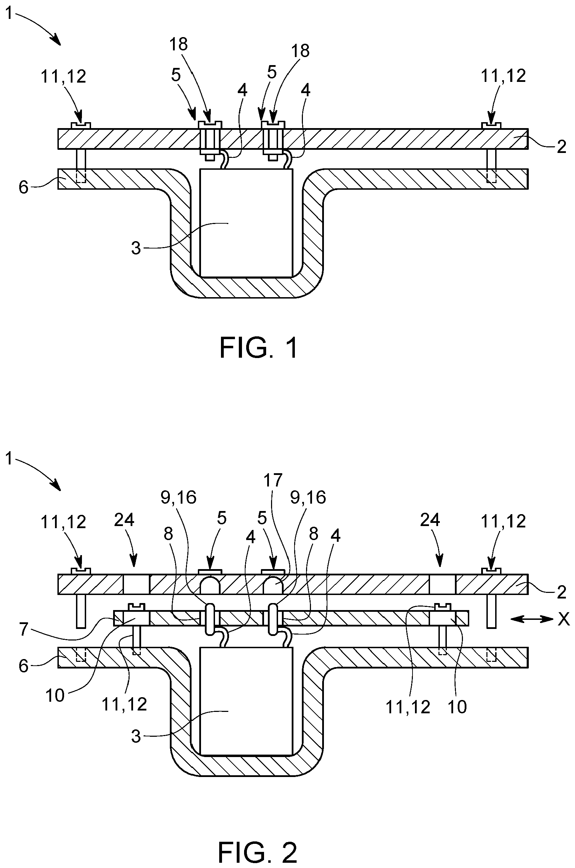

In Fig. 1 ist schematisch eine elektronische Baugruppe 1 mit einer Leiterplatte 2 und einem externen elektronischen Bauteil 3 nach dem Stand der Technik dargestellt. Im dargestellten Schnittbild ist die Leiterplatte 2, beispielsweise die Leistungselektronik eines Wechselrichters, mit externen elektronischen Bauteilen 3, beispielsweise entsprechenden Drosseln, über Kabel miteinander verbunden. Die Anschlüsse 4 der externen elektronischen Bauteile 3 werden über Befestigungsschrauben 18 mit den entsprechenden Kontakten 5 auf der Leiterplatte 2 verbunden. Die Leiterplatte 2 wird über entsprechende Befestigungselemente 11, insbesondere Befestigungsschrauben 12, mit dem Gehäuseteil 6 verbunden, insbesondere verschraubt. Der Gehäuseteil 6 kann gleichzeitig als Aufnahme für den externen elektronischen Bauteil 3 fungieren und diesen externen elektronischen Bauteil 3 auch gleichzeitig kühlen, indem der Gehäuseteil 6 aus Metall hergestellt wird und an entsprechend geeigneten Stellen Kühlrippen oder dgl. zur Abführung der Wärme aufweist (nicht dargestellt).

Die Herstellung und Lösung der Schraubverbindungen zur elektrischen Verbindung der Anschlüsse 4 der externen elektronischen Bauteile 3 mit den Kontakten 5 auf der Leiterplatte 2 mit den Befestigungsschrauben 18 gestaltet sich relativ aufwändig und kann oft nur manuell vorgenommen werden. Insbesondere bei herstellungsbedingten Toleranzen kann es besonders schwierig sein, die Befestigungsschrauben 18 an den richtigen Stellen anzuordnen, wodurch es auch zu einem Verkanten der Schrauben kommen kann, wodurch die Montage und Demontage noch weiter erschwert wird. In der Folge ist der Aufwand für eine Reparatur einer defekten elektronischen Baugruppe 1 relativ groß.

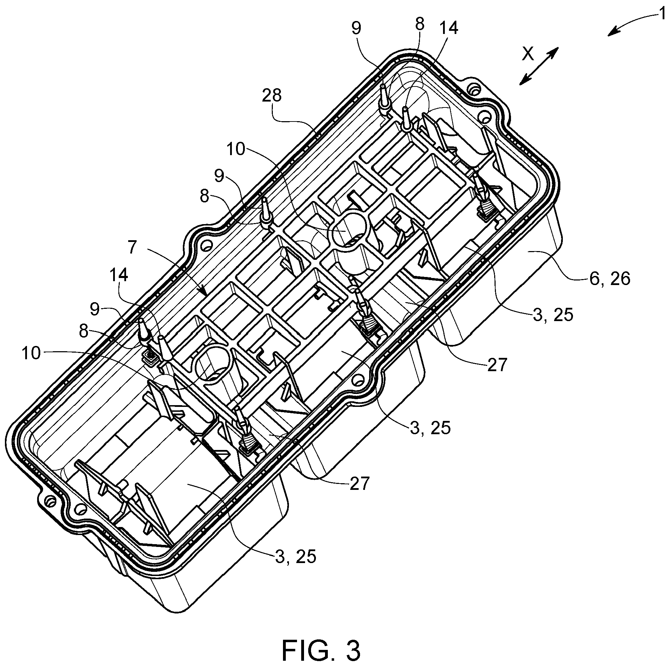

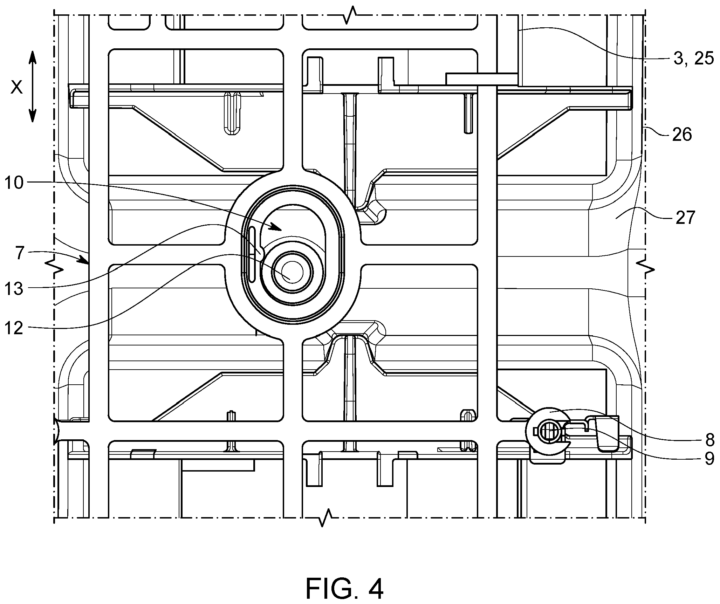

Fig. 2 zeigt schematisch eine elektronische Baugruppe 1 mit einer Leiterplatte 2 und einem externen elektronischen Bauteil 3 nach der vorliegenden Erfindung. Erfindungsgemäß ist ein am Gehäuseteil 6 verschiebbar gelagerter Träger 7 vorgesehen. Die Verschiebbarkeit in zumindest einer Richtung wird durch den horizontal angeordneten Doppelpfeil X neben dem Träger 7 veranschaulicht. Die Verschiebbarkeit des Trägers 7 gegenüber dem Gehäuseteil 6 in zumindest einer Richtung kann durch entsprechende Langlöcher 10 (siehe auch Fig. 3 und 4) einfach realisiert werden, in welchen Langlöchern 10 geeignete Befestigungselemente 11, insbesondere Befestigungsschrauben 12, zur Befestigung am Gehäuseteil 6 angeordnet werden. Am Träger 7 sind Halterungen 8 zur Aufnahme von Kontaktelementen 9 vorgesehen. Die in den Halterungen 8 des Trägers 7 angeordneten Kontaktelemente 9 sind in geeigneter Weise mit den Anschlüssen 4 der externen elektronischen Bauteile 3, beispielsweise Drosseln, verbunden. Weiters sind die Kontaktelemente 9 in den Halterungen 8 des Trägers 7 zur Verbindung mit den Kontakten 5 auf der Leiterplatte 2 ausgebildet. Im dargestellten Ausführungsbeispiel sind die Kontaktelemente 9 als Stecker 16 ausgebildet und die Kontakte 5 auf der Leiterplatte 2 durch entsprechend passende Buchsen 17. Ebenso könnten die Kontaktelement 9 auch ein Innengewinde zur Aufnahme einer Schraube mit einem entsprechenden Außengewinde aufweisen (nicht dargestellt).

Bei der Montage wird zunächst der Träger 7 mit dem externen elektronischen Bauteil 3 verbunden, indem die Kontaktelemente 9 in den dafür vorgesehenen Halterungen 8 des Trägers 7 angeordnet werden. Danach wird der Träger 7 provisorisch mit dem Gehäuseteil 6 verbunden, beispielsweise über die in den Langlöchern 10 angeordneten Befestigungsschrauben 12. Eine Verschiebung in Richtung des Doppelpfeiles X ist nach wie vor möglich. Danach wird die Leiterplatte 2 über dem Träger 7 angeordnet. Durch die Verschiebbarkeit des Trägers 7 und der daran angeordneten Kontaktelementen 9 können gewisse Toleranzen ausgeglichen werden und eine sichere Verbindung der Kontaktelemente 9 mit den Kontakten 5 auf der Leiterplatte 2 rasch ermöglicht werden. Im Falle einer durch die Stecker 16 und Buchsen 17 realisierte Steckverbindung kann die Verbindung der Kontaktelemente 9 bzw. der externen elektronischen Bauteile 3 mit den entsprechenden Kontakten 5 auf der Leiterplatte 2 rasch und werkzeuglos hergestellt und auch wieder gelöst werden. Wenn die Leiterplatte 2 mit den Kontaktelementen 9 am Träger 7 verbunden ist, kann sowohl der Träger 7 als auch die Leiterplatte 2 über entsprechende Befestigungselemente 11, insbesondere Befestigungsschrauben 12, am Gehäuseteil 6 befestigt werden. Gegebenenfalls sind in der Leiterplatte 2 entsprechende Öffnungen 24 angeordnet, um die allenfalls darunter angeordneten Befestigungselemente 11, insbesondere Befestigungsschrauben 12, mit geeigneten Werkzeugen (nicht dargestellt) betätigen zu können.

Es resultiert eine einfachere und raschere Befestigung und Lösung der Leiterplatte 2 an und von den externen elektronischen Bauteilen 3, wodurch eine Reparatur oder ein Tausch einzelner Komponenten der elektronischen Baugruppe 1 rascher ermöglicht wird.

In Fig. 3 ist eine perspektivische Ansicht auf einen speziell gestalteten Gehäuseteil 6 einer elektronischen Baugruppe 1 mit darin angeordneten externen elektronischen Bauteilen 3 gezeigt. Fig. 4 zeigt eine Detailansicht auf den Träger 7 aus Fig. 3 von oben. Beispielsweise handelt es sich bei dem Gehäuseteil 6 um eine Drosselschale 26, in der Drosseln 25 als externe elektronische Bauteile 3 angeordnet sind. Die Drosselschale 26 als Gehäuseteil 6 weist Räume für die Anordnung der Drosseln 25 auf, welche durch Stege 27 voneinander getrennt sind. Die Drosselschale 26 ist vorzugsweise aus Metall, insbesondere aus Aluminium oder einer Aluminiumlegierung, hergestellt, wodurch eine Kühlung der externen elektronischen Bauteile 3 gewährleistet wird. Am Rand der Drosselschale 26 kann eine Dichtung 28 angeordnet sein. Oberhalb der Drosseln 25 ist der erfindungsgemäße Träger 7 zur Unterstützung der Verbindung der Drosseln 25 als externe elektronische Bauteile 3 mit einer Leiterplatte 2 (nicht dargestellt) angeordnet. Der Träger 7 ist an der Drosselschale 26 verschiebbar gelagert. Zu diesem Zweck sind am Träger 7 Langlöcher 10 zur Aufnahme entsprechender Befestigungsschrauben 12 (siehe Detail in Fig. 4) angeordnet, welche Befestigungsschrauben 12 in dafür vorgesehene Gewinde in den Stegen 27 der Drosselschale 26 eingedreht werden können. Durch die Langlöcher 10 ist eine Verschiebung des Trägers 7 gegenüber der Drosselschale 26 in einer Richtung, der Längsachse des Langloches 10 entlang des Doppelpfeiles X, möglich. Im Langloch 10 kann eine Rastnase 13 zur Festlegung einer Vorzugsposition für das Befestigungselement 11, insbesondere die Befestigungsschraube 12, angeordnet sein (siehe Fig. 4). Bei Verschiebung des Trägers 7 in Richtung des Doppelpfeiles X muss dann ein kleiner Widerstand durch die Rastnase 13 überwunden werden.

Der Träger 7 weist Halterungen 8 zur Aufnahme von Kontaktelementen 9 auf, welche mit den Anschlüssen 4 der externen elektronischen Bauteilen 3 verbunden sind. Darüber hinaus dienen die in den Halterungen 8 des Trägers 7 angeordneten Kontaktelemente 9 zur Herstellung der Verbindung mit entsprechenden Kontakten 5 auf der Leiterplatte 2 (nicht dargestellt). Im dargestellten Ausführungsbeispiel sind die Kontaktelemente 9 durch Stecker 16 gebildet, welche mit komplementär gestalteten Buchsen 17 an der Leiterplatte 2 verbindbar sind (nicht dargestellt).

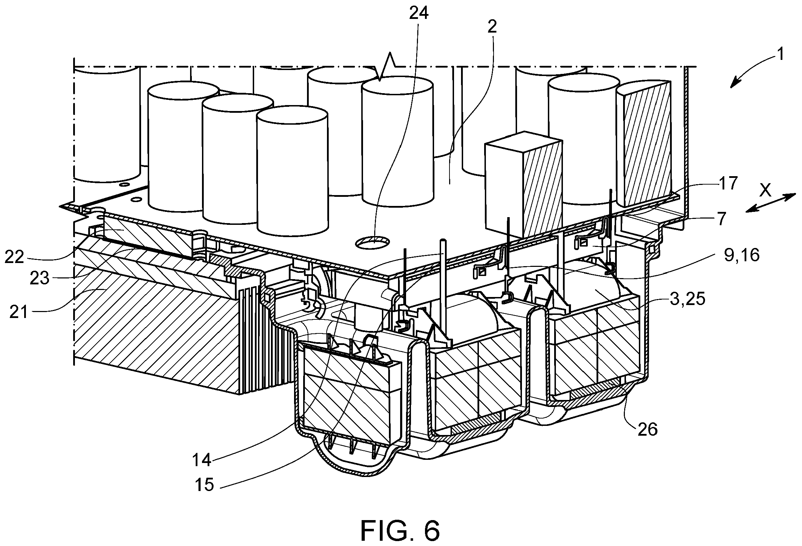

Der Träger 7 ist vorzugsweise aus Kunststoff, beispielsweise aus Polyamid, gebildet. Dadurch wird einerseits eine leichte Herstellbarkeit gewährleistet und andererseits die notwendige elektrische Isolierung der in den Halterungen 8 angeordneten Kontaktelementen 9 erzielt. Wenn der Träger 7 als Gitter ausgebildet ist, kann Material und somit Gewicht eingespart werden und es wird der Zugang zu den unter dem Träger angeordneten Komponenten, beispielsweise den externen elektronischen Bauteilen 3 bzw. Drosseln 25, ermöglicht. Am Träger 7 kann zumindest ein Zentrierstift 14 angeordnet sein, welcher in eine entsprechende Zentrieröffnung 15 an der Leiterplatte 2 anordenbar ist (siehe Fig. 6). Der Zentrierstift 14 kann ebenso wie die Langlöcher 10 und die Halterungen 8 für die Kontaktelemente 9 vorzugsweise in einem Herstellungsvorgang des Trägers 7, beispielsweise einem Spritzgießvorgang, einfach gebildet werden.

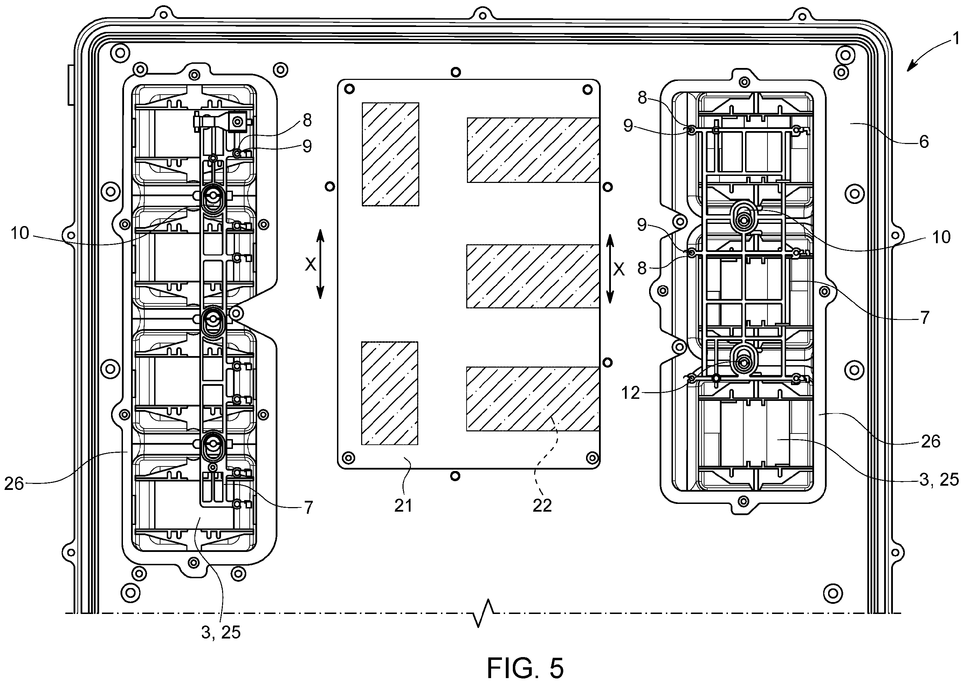

Fig. 5 ist eine Draufsicht auf eine elektronische Baugruppe 1 mit Gehäuseteilen 6 mit externen elektronischen Bauteilen 3, entsprechenden Trägern 7 und einem Kühlkörper 21 zur Kühlung von Bauteilen 22, welche an der Unterseite einer darüber anordenbaren Leiterplatte 2 (siehe Fig. 6) platziert sind. Bei der elektronischen Baugruppe 1 handelt es sich beispielsweise um den Leistungsteil eines Wechselrichters, insbesondere Photovoltaik-Wechselrichters, der zur Umwandlung der von Photovoltaikmodulen erzeugten Gleichspannung in eine Wechselspannung dient. Das Gehäuse bzw. der Gehäuseteil 6 des Wechselrichters beinhaltet zwei Drosselschalen 26 für den DC-seitigen Leistungsteil und den AC-seitigen Leistungsteil des Wechselrichters, in welchen die externen elektronischen Bauteile 3 in Form von Drosseln 25 angeordnet werden. Im linken DC-seitigen Leistungsteil sind vier Drosseln 25 angeordnet, während im rechten AC-seitigen Leistungsteil drei Drosseln 25 platziert sind. Erfindungsgemäß sind jeweils Träger 7 vorgesehen, welche am Gehäuseteil 6 verschiebbar (Doppelpfeile X) gelagert sind. Die verschiebliche Lagerung wird durch die Langlöcher 10 erzielt. Die gitterartig ausgebildeten Träger 7 weisen Halterungen 8 zur Aufnahme der Kontaktelemente 9 zur Verbindung mit den Anschlüssen 4 (nicht dargestellt) der externen Drosseln 25 auf. Zwischen den Drosselschalen 26 des DC-seitigen und AC-seitigen Leistungsteils des Wechselrichters ist ein Kühlkörper 21 aus einem geeigneten Material angeordnet. Dieser Kühlkörper 21 dient zur Kühlung von elektronischen Bauteilen 22 (durch strichliert schraffierte Flächen angedeutet), welche an der Unterseite der Leiterplatte 2 angeordnet sind, welche über den Drosselschalen 25 befestigt wird (siehe Fig. 6).

Fig. 6 zeigt einen Teil der elektronischen Baugruppe 1 gemäß Fig. 5 mit darüber angeordneter Leiterplatte 2. Beim Platzieren der Leiterplatte 2 über dem Träger 7 der Drosselschale 25 kommt es zur Kontaktierung der Kontaktelemente 9. Im dargestellten Ausführungsbeispiel sind die Kontaktelemente 9 durch Stecker 16 gebildet, welche in entsprechende Buchsen 17 auf der Leiterplatte 2 passen, um so eine elektrische Verbindung zwischen den externen Drosseln 26 und den Leiterbahnen auf der Leiterplatte 2 zu erzielen.

Zur Verbesserung der Wärmeleitung wird vorzugsweise zwischen den Bauteilen 22 und dem Kühlkörper 21 eine Wärmeleitpaste 23 angewendet. Diese Wärmeleitpaste 23, welche durch ein Phase Change Material gebildet sein kann, härtet üblicherweise aus, wodurch eine Demontage der Leiterplatte 2 erschwert wird. Hier bietet die verschiebbare Lagerung des Trägers 7 einen weiteren Vorteil neben dem Ausgleich von Toleranzen. Nach dem Lösen diverser Befestigungsschrauben 12, mit welchen die Leiterplatte 2 und die Träger 7 am Gehäuseteil 6 fixiert werden (nicht dargestellt), kann durch Verschiebung in Richtung des Doppelpfeiles X eine Lösung der Wärmeleitpaste 23 zwischen den Bauteilen 22 und dem Kühlkörper 21 erreicht werden und somit die Leiterplatte 2 mit den Bauteilen 22 vom Kühlkörper 21 gelöst werden. Zur Unterstützung der Bewegung können Öffnungen 24 in der Leiterplatte 2 angeordnet werden, in welche entsprechende Werkzeuge, wie zum Beispiel Schraubendreher, eingesetzt werden können, um die Leiterplatte 2 zu bewegen.

Erkennbar sind auch Zentrierstifte 14 am Träger 7, welche in entsprechende Zentrieröffnungen 15 auf der Leiterplatte 2 ragen.

Die vorliegende Erfindung erleichtert die Verbindung der Leiterplatte 2 mit externen elektronischen Bauteilen 3 und vereinfacht somit eine Montage und Demontage von Komponenten der elektronischen Baugruppe 1. Insbesondere bei Wechselrichtern mit derartig gestalteten Baugruppen wird eine Reparatur wesentlich vereinfacht und es können somit die Kosten gesenkt werden.

Eine Anwendung bei anderen Schaltungen, wie zum Beispiel Schweißgeräten oder Batterieladegeräten ist natürlich auch möglich und sinnvoll.

## Patentansprüche

1. Elektronische Baugruppe (1) mit zumindest einer Leiterplatte (2) und externen elektronischen Bauteilen (3) mit elektrischen Anschlüssen (4), wobei die Leiterplatte (2) Kontakte (5) zur Verbindung mit den Anschlüssen (4) der externen elektronischen Bauteile (3) aufweist, und die zumindest eine Leiterplatte (2) und die externen Bauteile (3) an einem Gehäuseteil (6) befestigbar sind, **dadurch gekennzeichnet, dass** ein am Gehäuseteil (6) verschiebbar gelagerter Träger (7) vorgesehen ist, wobei der Träger (7) Halterungen (8) zur Aufnahme von Kontaktelementen (9) zur Verbindung mit den Anschlüssen (4) der externen elektronischen Bauteile (3) und zur Verbindung mit den Kontakten (5) auf der Leiterplatte (2) aufweist.

2. Elektronische Baugruppe (1) nach Anspruch 1, **dadurch gekennzeichnet, dass** der Träger (7) in einer Richtung verschiebbar gelagert ist.

3. Elektronische Baugruppe (1) nach Anspruch 2, **dadurch gekennzeichnet, dass** der Träger (7) zumindest ein Langloch (10) zur Aufnahme eines Befestigungselements (11), insbesondere einer Befestigungsschraube (12), aufweist, welches Befestigungselement (11) mit dem Gehäuseteil (6) verbindbar ist.

4. Elektronische Baugruppe (1) nach Anspruch 3, **dadurch gekennzeichnet, dass** in zumindest einem Langloch (10) eine Rastnase (13) zur Festlegung einer Vorzugsposition für das Befestigungselement (11) angeordnet ist.

5. Elektronische Baugruppe (1) nach einem der Ansprüche 1 bis 4, **dadurch gekennzeichnet, dass** der Träger (7) aus Kunststoff, beispielsweise aus Polyamid, gebildet ist.

6. Elektronische Baugruppe (1) nach einem der Ansprüche 1 bis 5, **dadurch gekennzeichnet, dass** der Träger (7) als Gitter ausgebildet ist.

7. Elektronische Baugruppe (1) nach einem der Ansprüche 1 bis 6, **dadurch gekennzeichnet, dass** am Träger (7) zumindest ein Zentrierstift (14) angeordnet ist, welcher in eine entsprechende Zentrieröffnung (15) an der Leiterplatte (2) anordenbar ist.

8. Elektronische Baugruppe (1) nach einem der Ansprüche 1 bis 7, **dadurch gekennzeichnet, dass** das Kontaktelement (9) durch einen Stecker (16) gebildet ist, welcher mit einer komplementär gestalteten Buchse (17) an der Leiterplatte (2) verbindbar ist.

9. Elektronische Baugruppe (1) nach einem der Ansprüche 1 bis 8, **dadurch gekennzeichnet, dass** am Gehäuseteil (6) ein Kühlkörper (21) angeordnet, welcher Kühlkörper (21) mit an der Unterseite der Leiterplatte (2) angeordneten Bauteilen (22) kontaktierbar ist.

10. Elektronische Baugruppe (1) nach einem der Ansprüche 1 bis 9, **dadurch gekennzeichnet, dass** zwischen den Bauteilen (22) und dem Kühlkörper (21) eine Wärmeleitpaste (23) anordenbar ist.

11. Elektronische Baugruppe (1) nach einem der Ansprüche 1 bis 10, **dadurch gekennzeichnet, dass** die Leiterplatte (2) zumindest eine Öffnung (24) aufweist.

12. Elektronische Baugruppe (1) nach einem der Ansprüche 1 bis 11, **dadurch gekennzeichnet, dass** die externen elektronischen Bauteile (3) durch Drosseln (25) gebildet sind.

13. Elektronische Baugruppe (1) nach Anspruch 12, **dadurch gekennzeichnet, dass** die Drosseln (25) in Drosselschalen (26) angeordnet sind.

14. Wechselrichter, insbesondere Photovoltaik-Wechselrichter, mit einem Leistungsteil, **dadurch gekennzeichnet, dass** der Leistungsteil als elektronische Baugruppe (1) nach einem der Ansprüche 1 bis 13 ausgebildet ist.
